# EUROPÄISCHE PATENTSCHRIFT

(11) **EP 2 266 138 B1**
(45) Veröffentlichungstag und Bekanntmachung des Hinweises auf die Patenterteilung: **04.05.2016**
(21) Anmeldenummer: 09733631.7
(22) Anmeldetag: 10.03.2009
(51) Int. Cl.: H01L 25/16, H01L 23/34, H01L 23/66, H01P 5/08, H01L 23/13, H01L 23/14, H01L 23/00

(54) **MIKROWELLEN-BAUGRUPPE**
MICROWAVE ASSEMBLY
MODULE À MICROONDES

(30) Priorität: 16.04.2008 DE 102008019094; 05.06.2008 DE 102008026765
(43) Veröffentlichungstag der Anmeldung: 29.12.2010
(73) Patentinhaber: Rohde & Schwarz GmbH & Co. KG, 81671 München (DE)
(72) Erfinder: PERNDL, Werner, Dr., 85591 Vaterstetten (DE); REICHEL, Thomas, 85598 Baldham (DE)
(74) Vertreter: Körfer, Thomas
(86) Internationale Anmeldenummer: PCT/EP2009/001703
(87) Internationale Veröffentlichungsnummer: WO 2009/127300

(56) Entgegenhaltungen:
- EP-A- 0 747 997
- EP-A1- 1 736 520
- DE-A1- 10 313 590
- DE-A1-102007 013 968
- JP-A- 63 079 365
- US-A- 6 057 593
- US-A1- 2003 042 582
- COOPER P D ET AL: "MULTICHIP-ON-FLEX PLASTIC ENCAPSULATED MHDI-LOW COST SUBSTRATELESS MANUFACTURING FOR MICROWAVE AND MILLIMETERWAVE MODULES" 1996 IEEE MTT-S INTERNATIONAL MICROWAVE SYMPOSIUM DIGEST. SAN FRANCISCO, JUNE 17 - 21, 1996; [IEEE MTT-S INTERNATIONAL MICROWAVE SYMPOSIUM DIGEST], NEW YORK, IEEE, UI, 17. Juni 1996 (1996-06-17), Seiten 219-222, XP000704887 ISBN: 978-0-7803-3247-8

## Beschreibung

Die Erfindung betrifft eine Mikrowellen-Baugruppe laut Oberbegriff des Hauptanspruches.

Bei Mikrowellen-Baugruppen dieser Art besteht oftmals das Problem, von einem empfindlichen Halbleiterchip Wärme, die durch Verlustleistung der auf dem Chip angebrachten Bauelemente entsteht vom Chip möglichst gut abzuleiten. Ebenso entsteht z.B. bei thermischen Leistungssensoren die Anforderung, Temperaturgradienten auf einen Chip, die z.B. durch thermische Flüsse entstehen, klein zu halten. Die bisher z. B. aus der DE 10 2007 024 413 A1 hierfür vorgesehenen Lösungen, beispielsweise den Halbleiterchip mit seiner flachen Unterseite auf dem die Anschluss-Leitungsstruktur des Chips tragenden Mikrowellenschaltung aufzusetzen bzw. aufzukleben, lösen dieses Problem nur mangelhaft.

Aus der US 6,057,593 A ist eine Mikrowellen-Baugruppe mit einer in Hybrid-Technik integrierten Schaltung gemäß dem Oberbegriff des Patentanspruchs 1 bekannt.

Bei der DE 103 13 590 A1 ist die Verbindung zwischen einem koaxialen und koplanaren Leitungssystem in einem Gehäuse realisiert, in dem das koplanare Leitungssystem befestigt ist und in das das koaxiale Leitungssystem über die Einbaubuchse eingeführt ist. Die elektrische Verbindung besteht zwischen einem Mittelleiter des koplanaren Leitungssystems und einem Innenleiter des koaxialen Leitungssystems sowie zwischen den durch Schlitze vom Mittelleiter getrennten seitlichen Masseleitern des koplanaren Leitungssystems und einem Schirmmantel des koaxialen Leitungssystems über das Gehäuse und die Einbaubuchse. Die Befestigung des koplanaren Leitungssystems am Gehäuse erfolgt über eine elastische Verbindung an Anlageelementen des Gehäuses, so dass die Masseleiter elastisch gegen die Anlageelemente des Gehäuses geklemmt werden.

Die US 2003/0042582 A1 zeigt die Verbindung verschiedener Halbleiter-Bauelemente, wobei die Halbleiter-Bauelemente in entsprechende Vertiefungen eines Kühlkörpers eingelegt sind.

Bei dem Mikrowellen-Übergang der DE 10 2007 013 968 A1 von einer Koaxialleitung auf ein Koplanar-Leitungssystem setzt sich in einer Längsbohrung eines Außenleiter-Gehäuses der runde Innenleiter der Koaxialleitung in einem planaren Innenleiter in Form eines mindestens einseitig metallisierten schmalen Folienstücks aus elastisch nachgiebigem Isoliermaterial fort. Das Ende dieses planaren Innenleiters verschmälert sich anschließend in einem Übergangsabschnitt auf die Breite eines koplanaren Mittelleiters mit beidseitigen koplanaren Masseflächen.

Die JP 63-0799365 A zeigt eine Verbesserung der Wärmeabführung eines in ein Substrat eingebetteten Halbleiter-Chips.

Aus der EP 1 736 520 A1 ist bekannt, dass Kleber hoher Wärmeleitfähigkeit, die bei niedriger Temperatur so aushärten, dass thermische Spannungen bei der Herstellung vermieden werden, zum Kleben von Halbleiterchips auf Metallteile geeignet sind.

Es ist daher Aufgabe der Erfindung, für eine Mikrowellenbaugruppe der bezeichneten Art einen Aufbau zu schaffen, durch den die im Halbleiterchip entstehende Wärme möglichst gut an seine Umgebung abgeführt wird und der zugleich eine möglich konstante Temperaturverteilung über dem Chip sicherstellt.

Diese Aufgabe wird erfindungsgemäß durch eine Mikrowellen-Baugruppe laut Hauptanspruch 1 gelöst. Vorteilhafte Weiterbildungen ergeben sich aus den Unteransprüchen.

Durch das möglichst allseitige versenkte Einkleben des Halbleiterchips in einer Ausnehmung eines Metallteils von guter Wärmeleitung mittels eines Klebers ebenfalls von hoher Wärmeleitfähigkeit wird beste Wärmeabführung vom Halbleiterchip erreicht. Trotzdem wird eine einfache HF-Ankopplung der Anschluss-Leitungsstruktur des Halbleiterchips zu benachbarten Zu- bzw. Ableitungsstrukturen beispielsweise über Bond-Drähte oder kleine Folienstücke, auf deren Oberfläche entsprechende Verbindungsleitungsstrukturen ausgebildet sind, möglich. Die Erfindung ist daher beispielsweise besonders vorteilhaft für thermische Leistungsmesszellen, die auf einem Halbleiterchip angebracht sind und denen von außen über eine Mikrowellen-Abschlussleitungsstruktur die zu messende Hochfrequenz zugeführt wird und von denen jegliche die Messung verfälschende Wärmezufuhr von außen vermieden werden muss. Die Erfindung ist jedoch in gleicher Weise beispielsweise bei Halbleiterchips anwendbar, auf denen Verlustleistung erzeugende aktive Bauelemente, beispielsweise Hochfrequenz-Leistungsverstärkerelemente oder dergleichen ausgebildet sind und bei denen diese Verlustleistungswärme so gut wie möglich vom Chip abgeführt werden muss.

Die Erfindung wird im Folgenden anhand einer schematischen Zeichnung an einem Ausführungsbeispiel näher erläutert. Es zeigen:
- Fig. 1: eine Draufsicht auf eine erfindungsgemäße Mikrowellen-Baugruppe
- Fig. 2: einen Schnitt, längs der Linie A - A nach Fig. 1

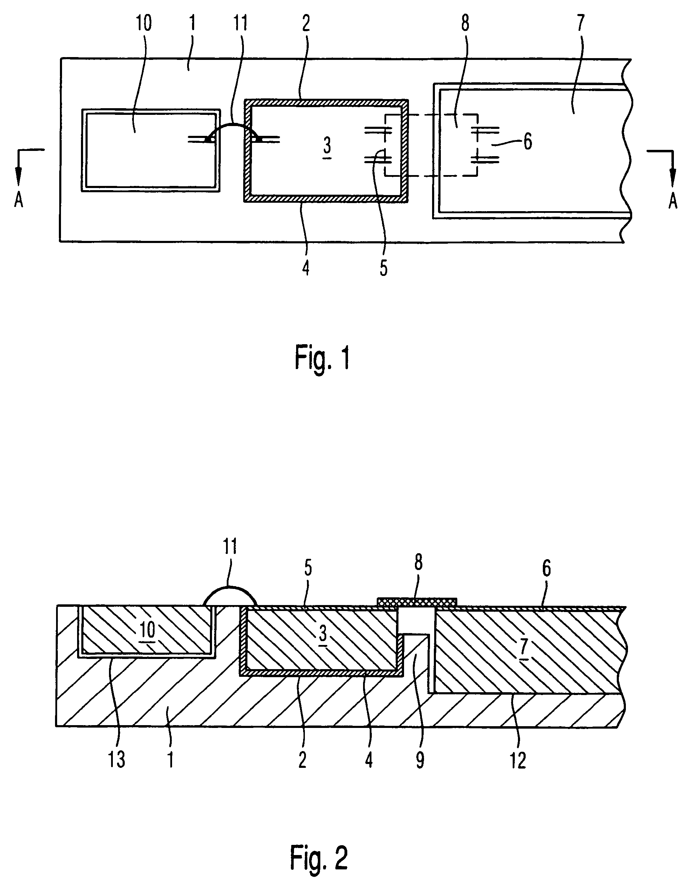

Die in Fig. 1 dargestellte Mikrowellen-Baugruppe besteht aus einem flachen Metallteil 1 guter Wärmeleitung, beispielsweise Kupfer. In einer ersten flachen Ausnehmung 2 ist ein Halbleiterchip 3 eingesetzt. Die Figuren zeigen die Baugruppe in stark vergrößertem Maßstab, die Dicke des dargestellten Halbleiterchips beträgt beispielsweise nur 200 µm, die Seitenabmessungen nur 1 - 2 mm. Die Ausnehmung 2 entspricht in ihrem Umriss dem des Halbleiterchips 3.
Der im eingesetzten Zustand zwischen Chip 3 und den Seitenwänden der Ausnehmung 2 bestehende Spalt ist möglichst klein und beträgt beispielsweise nur 30 - 50 µm. Der Chip 3 ist allseits in die Ausnehmung 2 eingeklebt, das heißt der Spalt zwischen dem Boden und den Seitenwänden der Ausnehmung 2 und der Unterseite bzw. den Seitenflächen des Chips 3 ist vollständig mit Klebstoff ausgefüllt. Als Kleber eignet sich Kleber hoher Wärmeleitfähigkeit, so dass eine gute thermische Verbindung zwischen Halbleiterchip 3 und dem umgebenden Metallteil 1 hergestellt wird. Vorzugsweise wird ein Kleber verwendet, der bei relativ niedriger Temperatur aushärtet, so dass thermische Spannungen bei der Herstellung vermieden werden.

Auf der Oberseite des Halbleiterchips ist eine schematisch angedeutete Anschluss-Leitungsstruktur 5 für die auf dem Chip ausgebildeten Halbleiter-Bauelemente vorgesehen, die mit benachbarten Zu- und/oder Ableitungs-Leitungsstrukturen 6 eines benachbarten Substrats 7 elektrisch verbunden ist. Für eine Hochfrequenz-Verbindung können dafür beispielsweise Bond-Drähte oder eine auf einem kleinen Folienstück 8 ausgebildete Verbindungsleitungsstruktur dienen. Vorzugsweise wird im Bereich dieser HF-Verbindung die Wand 9 der den Chip aufnehmenden Ausnehmung 2 in der Höhe verringert, beispielsweise nur halbhoch ausgebildet, so dass störende Einflüsse auf das HF-Feld der HF-Verbindung 8 vermieden werden. Wenn zwischen Chip 3 und einem benachbarten Substrat 10 nur eine Niederfrequenz- bzw. Gleichstrom-Verbindung erforderlich ist, wie dies für die andere Seite des Chips in Fig. 1 dargestellt ist, ist eine solche Verringerung der Seitenwandhöhe nicht erforderlich, da hier die beispielsweise zur Verbindung dienenden Bond-Drähte diesen Metallsteg entsprechend überbrücken können.

Die benachbarten Substrate 7 bzw. 10, meist aus Keramik, auf deren Oberflächen die Zu- bzw. Ableitungs-Leitungsstrukturen für Hochfrequenz bzw. Niederfrequenz oder Gleichstrom ausgebildet sind, sind ebenfalls in entsprechenden Ausnehmungen 12 bzw. 13 des Metallteiles 1 eingesetzt und vorzugsweise ebenfalls dort allseitig eingeklebt.

Die Anschluss-Leitungsstruktur 5 auf dem Chip 3 ist vorzugsweise eine Koplanar-Leitungsstruktur, könnte aber auch in Mikro-Streifenleitungstechnik ausgebildet sein. Entsprechendes gilt für die Zu- bzw. Ableitungs-Leitungsstruktur 6 auf dem benachbarten Substrat 7 für den HF-Anschluss. Wenn beide Leitungsstrukturen 5 und 6 Koplanarleitungen sind, eignet sich zur Verbindung insbesondere ein in Fig. 1 gestrichelt angedeutetes kleines Folienstück 8, auf dem die Verbindungsleitungsstruktur ebenfalls in Koplanarleitungstechnik ausgebildet ist. Dieses kleine Folienstück 8 kann z.B. per Thermokompressionsverfahren unmittelbar auf der Oberseite des Chips 3 bzw. des Substrats 7 beispielsweise aus Keramik aufgebracht werden. Die Tiefe der Ausnehmung 2 für den Chip 3 bzw. für die Keramiksubstrate 7 bzw. 10 richtet sich nach der Dicke dieser Teile. Vorzugsweise wird die Tiefe dieser Ausnehmungen im Metallteil 1 so gewählt, dass die Oberflächen der eingeklebten Teile 2, 7 und 10 möglichst in einer Ebene liegen, da dann die Anbringung der Verbindungsleitungen erleichtert wird. Andererseits ist vor allem bei Verwendung eines Folienstückes 8 bzw. von Bond-Drähten 11 eine solche Oberflächen-fluchtende Anordnung nicht unbedingt erforderlich, da sowohl durch die Folie als auch durch die Bonddrähte eventuelle Höhenunterschiede leicht ausgeglichen werden können.

Als besonders vorteilhaft hat es sich erwiesen, als Zu- bzw. Ableitungs-Leitungsstruktur für die Hochfrequenz einen Koplanar-Mikrowellen-Übergang zu benutzen, da hierdurch einerseits eine optimale thermische Ableitung vom Halbleiterchip und andererseits die beste HF-Ankopplung ohne störende Reflexionen erreicht wird. Bei diesem Mikrowellen-Übergang von einer Koaxialleitung auf eine Koplanar-Leitung setzt sich die Koaxialleitung in einem planaren Innenleiter in Form eines mindestens einseitig metallisierten schmalen Folienstücks aus elastischem Isoliermaterial fort und das Ende dieses planaren Innenleiters verschmälert sich in einem anschließenden Übergangsabschnitt auf die Breite eines koplanaren Mittelleiters, an den beidseitig zum Mittelleiterabschnitt des Übergangsabschnittes Masseflächen herangeführt sind. Der Übergangsabschnitt ist dabei vorzugsweise auf dem das Koplanar-Leitungssystem aufweisenden Substrat ausgebildet, das in diesem Fall dann dem Substrat 7 des Ausführungsbeispiels entspricht.

Die Anmeldung ist nicht auf das dargestellte Ausführungsbeispiel beschränkt. Alle beschriebenen und/oder gezeichneten Merkmale sind im Rahmen der Erfindung beliebig miteinander kombinierbar.

## Patentansprüche

1. Mikrowellen-Baugruppe mit mindestens einem Halbleiterchip (3), der auf seiner Oberseite eine Anschluss-Leitungsstruktur (5) aufweist und in einer Ausnehmung (2) eines Metallteils (1) guter Wärmeleitung eingesetzt ist und dessen Anschluss-Leitungsstruktur (5) mit mindestens einer benachbarten, auf der Oberseite eines Substrates (7, 10) ausgebildeten Zu-und/oder Ableitungs-Leitungsstruktur (6) verbunden ist,
wobei der Halbleiterchip (3) mit seiner Unterseite und seinen Seitenflächen in der Ausnehmung (2) des Metallteiles (1) mittels eines Klebers hoher Wärmeleitfähigkeit eingeklebt ist,
wobei ein Kleber verwendet ist, der bei niedriger Temperatur so aushärtet, dass thermische Spannungen bei der Herstellung vermieden werden,
und wobei auf seiner Oberseite das Zu- und/oder Ableitungs-Leitungsstruktur (6) aufweisende Substrat (7, 10) in einer von der Ausnehmung (2) des Halbleiterchips (3) getrennten Ausnehmung (12, 13) des Metallteiles (1) so eingeklebt ist, dass seine Oberfläche in der gleichen Ebene wie die Oberfläche des Halbleiterchips (3) liegt, **dadurch gekennzeichnet,**
**dass** der Halbleiterchip (3) allseits in die Ausnehmung (2) so eingeklebt ist, dass ein Spalt zwischen dem Boden und den Seitenwänden der Ausnehmung (2) und der Unterseite bzw. den Seitenflächen des Halbleiterchips (3) vollständig mit dem Kleber ausgefüllt ist.

2. Mikrowellen-Baugruppe nach Anspruch 1,
**dadurch gekennzeichnet,**
**dass** die Anschluss-Leitungsstruktur (5) des Halbleiterchips (3) mit der Zu- und/oder Ableitungs-Leitungsstruktur (6) des Substrats (7, 10) über Bond-Drähte (11) und/oder über ein Folienstück (8) mit entsprechender Verbindungsleitungsstruktur verbunden ist.

3. Mikrowellen-Baugruppe nach Anspruch 1 oder 2,
**dadurch gekennzeichnet,**
**dass** als Zu- und/oder Ableitungsleitungsstruktur ein Mikrowellen-Übergang dient, bei dem sich eine Koaxialleitung in einem planaren Innenleiter in Form eines metallisierten schmalen Folienstücks aus elastischem Isoliermaterial fortsetzt und das Ende dieses planaren Innenleiters sich in einem anschließenden
Übergangsabschnitt auf die Breite eines koplanaren Mittelleiters verschmälert, an den beidseitig zu einem Mittelleiterabschnitt des Übergangsabschnittes Masseflächen herangeführt sind.

4. Mikrowellen-Baugruppe nach Anspruch 3, **dadurch gekennzeichnet,**
**dass** der Übergangsabschnitt auf dem Substrat (7) ausgebildet ist.

5. Mikrowellen-Baugruppe nach einem der Ansprüche 1 bis 4, **dadurch gekennzeichnet,**
**dass** der Halbleiterchip (3) auf seiner Oberseite eine als Koplanarleitung ausgebildete Anschluss-Leitungsstruktur (5) aufweist.

## Claims

1. Microwave assembly with at least one semiconductor chip (3) which on its upper side exhibits a connecting line structure (5) and is inserted in a recess (2) of a metal part (1) having good thermal conduction and the connecting line structure (5) of which is connected with at least one adjacent incoming and/or outgoing line structure (6) formed on the upper side of a substrate (7, 10),
wherein the semiconductor chip (3) is glued with its underside and its side faces in the recess (2) of the metal part (1) by means of an adhesive having high thermal conductivity,
wherein an adhesive is used which sets at low temperature so that thermal stresses are avoided during production, and wherein on its upper side the substrate (7, 10) exhibiting the incoming and/or outgoing line structure (6) is glued in a recess (12, 13) of the metal part (1) separated from the recess (2) of the semiconductor chip (3) so that its surface lies in the same plane as the surface of the semiconductor chip (3),
**characterised in that**
the semiconductor chip (3) is glued into the recess (2) on all sides so that a gap between the bottom and the side walls of the recess (2) and the underside and the side faces respectively of the semiconductor chip (3) is completely filled with the adhesive.

2. Microwave assembly according to claim 1, **characterised in that**
the connecting line structure (5) of the semiconductor chip (3) is connected with the incoming and/or outgoing line structure (6) of the substrate (7, 10) by means of bond wires (11) and/or by means of a piece of foil (8) with a corresponding connecting line structure.

3. Microwave assembly according to claim 1 or 2, **characterised in that**
a microwave junction is used as the incoming and/or outgoing line structure, in which a coaxial line in a planar internal conductor is continued in the form of a metallised narrow piece of foil made of elastic
insulating material and the end of this planar internal conductor narrows in an adjoining junction section to the width of a coplanar central conductor to which grounding faces are run on both sides of a central conductor section of the junction section.

4. Microwave assembly according to claim 3, **characterised in that**
the junction section is formed on the substrate (7).

5. Microwave assembly according to one of claims 1 to 4,
**characterised in that**
on its upper side the semiconductor chip (3) exhibits a connecting line structure (5) embodied in the form of a coplanar line.

## Revendications

1. Module micro-ondes comportant au moins une puce semi-conductrice (3), qui présente sur son côté supérieur une structure de ligne de connexion (5) et est insérée dans un évidement (2) d'une partie métallique (1) à conductivité thermique satisfaisante et dont la structure de ligne de connexion (5) est reliée à au moins une structure de ligne d'amenée et/ou de dérivation (6) adjacente réalisée sur le côté supérieur d'un substrat (7, 10),
dans lequel la puce semi-conductrice (3) est collée par son côté inférieur et ses côtés latéraux dans l'évidement (2) de la partie métallique (1) au moyen d'une colle à conductivité thermique élevée,
dans lequel une colle est utilisée, qui durcit à faible température de sorte que des tensions thermiques lors de la fabrication sont évitées,
et dans lequel, sur son côté supérieur, le substrat (7, 10) présentant la structure de ligne d'amenée et/ou de dérivation (6) est collé dans un évidement (12, 13) de la partie métallique (1) distinct de l'évidement (2) de la puce semi-conductrice (3) de sorte que sa surface se trouve dans le même plan que la surface de la puce semi-conductrice (3),
**caractérisé en ce que**
la puce semi-conductrice (3) est collée sur tous ses côtés dans l'évidement (2) de sorte qu'un intervalle entre le fond et les parois latérales de l'évidement (2) et le fond ou les parois latérales de la puce semi-conductrice (3) est complètement rempli par la colle.

2. Module micro-ondes selon la revendication 1, **caractérisé en ce que**
la structure de ligne de connexion (5) de la puce semi-conductrice (3) est reliée à la structure de ligne d'amenée et/ou de dérivation (6) du substrat (7, 10) par l'intermédiaire de fils de liaison (11) et/ou par l'intermédiaire d'un morceau de feuille (8) avec la structure de ligne de liaison appropriée.

3. Module micro-ondes selon la revendication 1 ou 2, **caractérisé en ce que**
en tant que structure de ligne d'amenée et/ou de dérivation est utilisée une transition micro-ondes, dans lequel une ligne coaxiale se continue dans un conducteur interne planaire sous la forme d'un morceau de feuille mince métallisé en matériau isolant élastique et l'extrémité de ce conducteur interne planaire se réduit dans un tronçon de transition consécutif à la largeur d'un conducteur central coplanaire, sur lequel les surfaces de masse sont amenées sur les deux côtés à un tronçon de conducteur central du tronçon de transition.

4. Module micro-ondes selon la revendication 3, **caractérisé en ce que**
le tronçon de transition est réalisé sur le substrat (7).

5. Module micro-ondes selon l'une des revendications 1 à 4, **caractérisé en ce que**
la puce semi-conductrice (3) présente sur son côté supérieur une structure de ligne de connexion (5) réalisée en tant que ligne coplanaire.
